(19)

Europäisches
Patentamt
European
Patent Office
Office européen
des brevets

(11) **EP 4 166 845 A1**

(12) **EUROPEAN PATENT APPLICATION**
published in accordance with Art. 153(4) EPC

(43) Date of publication:
**19.04.2023 Bulletin 2023/16**

(21) Application number: **21821627.3**

(22) Date of filing: **10.06.2021**

(51) International Patent Classification (IPC):
*F21V 29/502* (2015.01)     *F21Y 105/10* (2016.01)
*F21Y 107/50* (2016.01)     *F21Y 115/10* (2016.01)
*F21Y 115/30* (2016.01)     *F21S 2/00* (2016.01)
*F21V 3/00* (2015.01)     *F21V 9/32* (2018.01)
*F21V 9/38* (2018.01)     *H01S 3/042* (2006.01)
*H01S 3/0941* (2006.01)     *H01S 3/10* (2006.01)

(52) Cooperative Patent Classification (CPC):
**F21S 2/00; F21V 3/00; F21V 9/32; F21V 9/38;
F21V 29/502; H01S 3/042; H01S 3/0941;
H01S 3/10;** F21Y 2105/10; F21Y 2107/50;
F21Y 2115/10; F21Y 2115/30

(86) International application number:
**PCT/JP2021/022166**

(87) International publication number:
**WO 2021/251470 (16.12.2021 Gazette 2021/50)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **12.06.2020 JP 2020102577**

(71) Applicant: **Panasonic Intellectual Property
Management Co., Ltd.
Osaka-shi, Osaka 540-6207 (JP)**

(72) Inventors:
• **AKETA, Takanori
Chuo-ku, Osaka-shi, Osaka 540-6207 (JP)**
• **TANAKA, Kenichiro
Chuo-ku, Osaka-shi, Osaka 540-6207 (JP)**
• **TSUBAKIMOTO, Koji
Osaka 565-0871 (JP)**
• **MIYANAGA, Noriaki
Osaka 565-0871 (JP)**

(74) Representative: **Müller-Boré & Partner
Patentanwälte PartG mbB
Friedenheimer Brücke 21
80639 München (DE)**

(54) **LIGHT EMITTING DEVICE AND LIGHT EMITTING SYSTEM**

(57)     Provided are a light-emitting device and light-emitting system with the ability to provide higher output power. A light-emitting device (1) includes an optical amplifier (2) and gives off output light from the optical amplifier (2) by making a plurality of seed light rays, having mutually different wavelengths, incident on the optical amplifier (2). The optical amplifier (2) includes a medium portion (20) containing a wavelength-converting element. The optical amplifier (2) has the wavelength-converting element thereof excited by excitation light to produce a plurality of partially coherent light rays, of which wavelengths are respectively the same as the mutually different wavelengths of the plurality of seed light rays (P2), thereby giving off, as the output light (P5), a multi-wavelength light beam. The excitation light has a shorter wavelength than any of the plurality of seed light rays (P2) and is incident on the medium portion (20). The multi-wavelength light beam includes a plurality of light rays (P4) amplified. The plurality of light rays (P4) amplified have wavelengths, which are respectively the same as the mutually different wavelengths of the plurality of seed light rays (P2).

FIG. 1

EP 4 166 845 A1

**Description**

**Technical Field**

The present disclosure generally relates to a light-emitting device and a light-emitting system, and more particularly relates to a light-emitting device and light-emitting system that use excitation light.

**Background Art**

A light source device including a solid-state light source and a light transmission fiber has been proposed in the art as a light-emitting device (see, for example, Patent Literature 1). The light transmission fiber has a first end face and a second end face, and excitation light emitted from the solid-state light source is introduced into the light transmission fiber through the first end face thereof. The light transmission fiber includes a wavelength-converting core, a light-guiding core, and a clad. The wavelength-converting core contains a wavelength-converting material that produces a population inversion state of electrons by absorbing the excitation light and that lets wavelength-converted light, falling within the visible radiation range, emerge therefrom. The light-guiding core covers the peripheral surface of the wavelength-converting core and transmits the wavelength-converted light from the first end face toward the second end face. The clad covers the peripheral surface of the light-guiding core.

The light transmission fiber is configured to have a stimulated emission produced by the wavelength-converted light propagating through the light-guiding core and to let not only the excitation light, emitted from the solid-state light source, but also the wavelength-converted light, amplified by the stimulated emission, emerge from the second end face.

Such a light-emitting device that uses excitation light is sometimes required to have its output power further increased.

**Citation List**

**Patent Literature**

Patent Literature 1: JP 2018-195627 A

**Summary of Invention**

It is therefore an object of the present disclosure to provide a light-emitting device and light-emitting system with the ability to provide higher output power.

A light-emitting device according to an aspect of the present disclosure includes an optical amplifier and gives off output light from the optical amplifier by making a plurality of seed light rays, having mutually different wavelengths, incident on the optical amplifier. The optical amplifier includes a medium portion containing a wavelength-converting element. The optical amplifier has the wavelength-converting element thereof excited by excitation light to produce a plurality of partially coherent light rays, of which wavelengths are respectively the same as the mutually different wavelengths of the plurality of seed light rays, thereby giving off, as the output light, a multi-wavelength light beam. The excitation light has a shorter wavelength than any of the plurality of seed light rays and has been incident on the medium portion. The multi-wavelength light beam includes a plurality of light rays amplified. The plurality of light rays amplified have wavelengths, which are respectively the same as the mutually different wavelengths of the plurality of seed light rays.

A light-emitting system according to another aspect of the present disclosure includes: the light-emitting device described above; a first light source unit that emits the excitation light; and a second light source unit that emits the plurality of seed light rays.

**Brief Description of Drawings**

FIG. 1 illustrates a configuration for a light-emitting system including a light-emitting device according to a first embodiment;
FIG. 2 illustrates a configuration for the light-emitting system including the light-emitting device with the light-emitting device exploded;
FIG. 3A is a plan view illustrating a main part of the light-emitting system including the light-emitting device;
FIG. 3B is a cross-sectional view illustrating the main part of the light-emitting system including the light-emitting device;

FIG. 4 illustrates how the light-emitting system including the light-emitting device operates;

FIG. 5 illustrates an operating principle of the light-emitting device;

FIG. 6 shows an emission spectrum of the light-emitting device;

FIG. 7 illustrates a configuration for another exemplary light-emitting system including the light-emitting device according to the first embodiment;

FIG. 8 illustrates a configuration for still another exemplary light-emitting system including the light-emitting device according to the first embodiment;

FIG. 9 illustrates a configuration for a light-emitting system including a light-emitting device according to a first variation of the first embodiment;

FIG. 10 is a cross-sectional view of a light-emitting device according to a second variation of the first embodiment;

FIG. 11A is a plan view illustrating a main part of a light-emitting system including a light-emitting device according to a third variation of the first embodiment;

FIG. 11B is a cross-sectional view illustrating the main part of the light-emitting system including the light-emitting device;

FIG. 12 is a plan view illustrating a main part of a light-emitting system including a light-emitting device according to a fourth variation of the first embodiment;

FIG. 12B is a cross-sectional view illustrating the main part of the light-emitting system including the light-emitting device;

FIG. 13 is a cross-sectional view illustrating a main part of a light-emitting system including a light-emitting device according to a second embodiment;

FIG. 14 illustrates a configuration for a light-emitting system including a light-emitting device according to a third embodiment;

FIG. 15 illustrates a configuration for the light-emitting system including the light-emitting device with the light-emitting device exploded;

FIG. 16 is a perspective view of an optical amplifier included in a light-emitting device according to a fourth embodiment;

FIG. 17 shows refractive index-wavelength characteristics of fluorides for use as materials for the optical amplifier of the light-emitting device;

FIG. 18 illustrates a configuration for a light-emitting system including a light-emitting device according to a fifth embodiment; and

FIG. 19 illustrates a configuration for a light-emitting system according to a sixth embodiment.

## Description of Embodiments

The drawings to be referred to in the following description of first to sixth embodiments and their variations are all schematic representations. Thus, the ratio of the dimensions (including thicknesses) of respective constituent elements illustrated on the drawings does not always reflect their actual dimensional ratio.

(First embodiment)

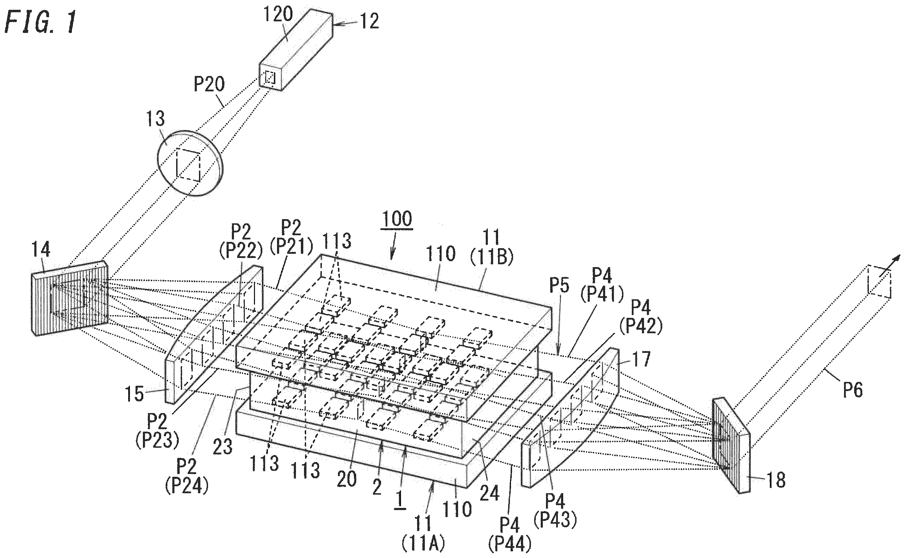

A light-emitting device 1 and light-emitting system 100 according to a first embodiment will now be described with reference to FIGS. 1-6.

(1) Overview

A light-emitting device 1 according to a first embodiment includes an optical amplifier 2 and gives off output light P5 from the optical amplifier 2 by making a plurality of seed light rays P2, having mutually different wavelengths, incident on the optical amplifier 2.

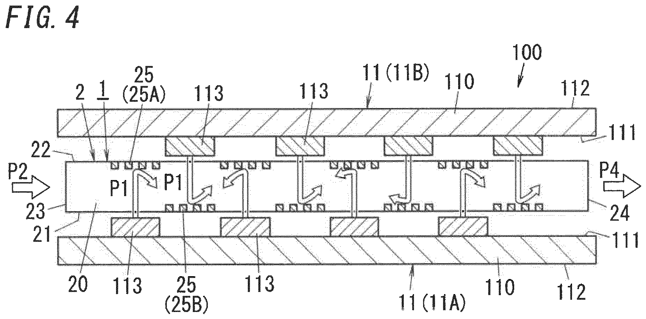

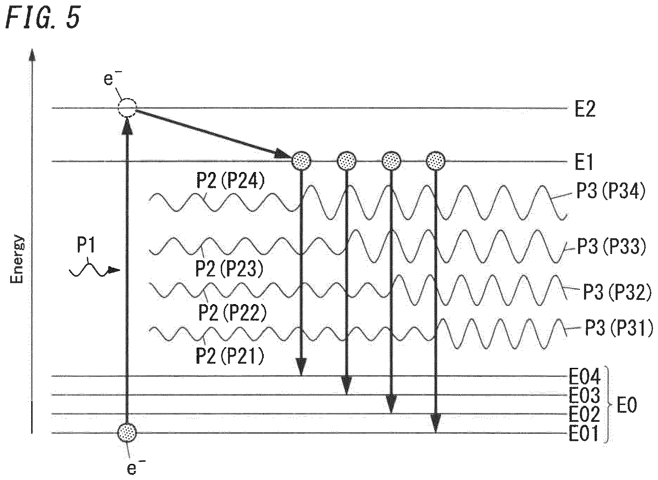

A light-emitting system 100 includes: the light-emitting device 1; a first light source unit 11 that emits excitation light P1 (refer to FIGS. 4 and 5); and a second light source unit 12 that emits the plurality of seed light rays P2. The light-emitting system 100 includes a pair of first light source units 11.

The light-emitting device 1 and light-emitting system 100 may be used in, for example, lighting fixtures, lighting devices, lighting systems, projectors, printers, and light sources for endoscopes. The light-emitting device 1 is applicable to not only various types of devices, systems, and other equipment for dwelling houses but also various types of devices, systems, and other equipment for other types of facilities and numerous types of moving vehicles. Examples of moving vehicles to which the light-emitting device 1 is applicable include automobiles, bicycles, railway trains, aircrafts, watercrafts, and drones.

(2) Configuration for light-emitting device

The light-emitting device 1 according to the first embodiment includes an optical amplifier 2 as shown in FIGS. 1-4. In addition, the light-emitting device 1 according to the first embodiment further includes a lens 17 for condensing the output light P5 emerging from the optical amplifier 2 and a transmissive diffraction grating 18 on which the light condensed by the lens 17 is incident.

The optical amplifier 2 includes a medium portion 20 containing a wavelength-converting element (such as a rare-earth element). The optical amplifier 2 has the wavelength-converting element thereof excited by excitation light P1 (refer to FIGS. 4 and 5) to not only produce a plurality of partially coherent light rays P3 (refer to FIG. 5), of which wavelengths are respectively the same as the mutually different wavelengths of the plurality of seed light rays P2, but also give off, as the output light P5, a multi-wavelength light beam by amplifying the seed light rays P2. The excitation light P1 has a shorter wavelength than any of the plurality of seed light rays P2 and is incident on the medium portion 20. The multi-wavelength light beam includes a plurality of light rays P4 amplified. The plurality of light rays P4 amplified have wavelength which are respectively the same as the mutually different wavelengths of the plurality of seed light rays P2. The light-emitting device 1 gives off output light P6 by having the plurality of light rays P4, included in the output light P5 emerging from the optical amplifier 2, synthesized by the lens 17 and the transmissive diffraction grating 18.

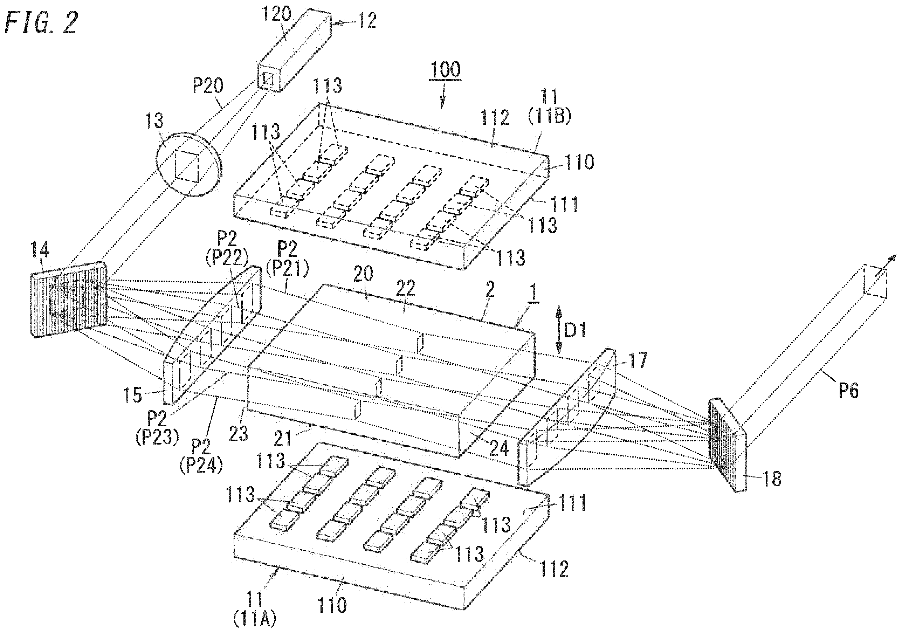

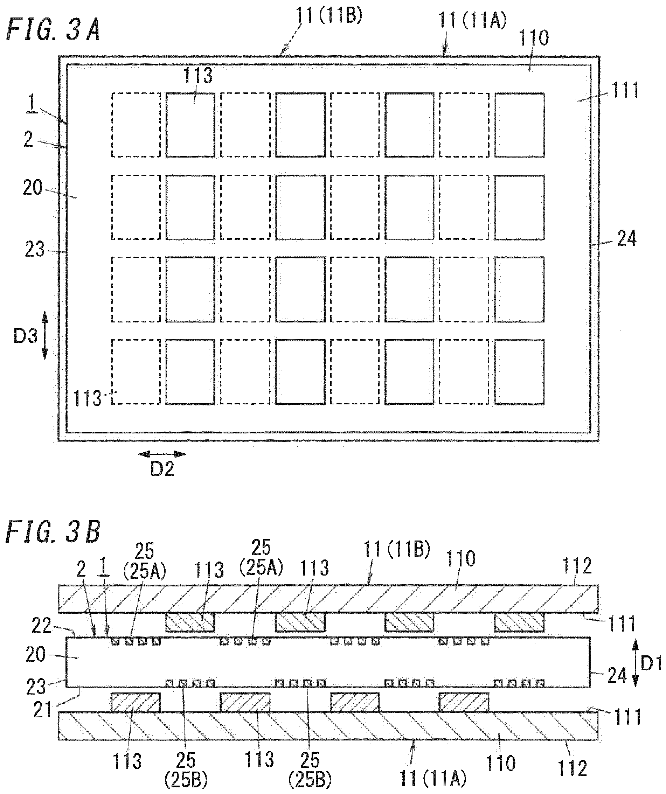

The medium portion 20 has a plate shape. In this embodiment, the medium portion 20 may have, for example, a rectangular plate shape. The medium portion 20 may have, for example, a rectangular planar shape when viewed in the thickness direction D1 (refer to FIGS. 2 and 3B). However, this is only an example and should not be construed as limiting. Alternatively, the medium portion 20 may also have a square planar shape. The medium portion 20 has a first surface 21 and a second surface 22 which face each other in the thickness direction D1 (refer to FIG. 3B) defined for the medium portion 20. As used herein, the phrase "facing" refers to facing geometrically, not physically. Therefore, the medium portion 20 has the first surface 21 and the second surface 22 opposite from the first surface 21. In the medium portion 20, the excitation light P1 is incident on each of the first surface 21 and the second surface 22. In the following description, the thickness direction D1 defined for the medium portion 20 will be hereinafter referred to as a "first direction D1," a direction in which the plurality of seed light rays P2 are incident on the medium portion 20 and which is perpendicular to the first direction D1 will be hereinafter referred to as a "second direction" (refer to FIG. 3A), and a direction perpendicular to both the first direction D1 and the second direction D2 will be hereinafter referred to as a "third direction" (refer to FIG. 3A) for the sake of convenience of description.

In addition, the medium portion 20 also has a light incident surface 23 and a light emergent surface 24 which face each other in the second direction D2. As used herein, the phrase "facing" refers to facing geometrically, not physically. Therefore, the medium portion 20 has the light incident surface 23 and the light emergent surface 24 opposite from the light incident surface 23. In the medium portion 20, the plurality of seed light rays P2 are incident on the light incident surface 23 and the output light P5 emerges from the light emergent surface 24. On the light incident surface 23, a plurality of regions, on which the plurality of seed light rays P2 are incident, are spaced from each other in the third direction D3.

The medium portion 20 contains a light-transmitting material and the wavelength-converting element. In this embodiment, the medium portion 20 may be a transparent ceramic containing the light-transmitting material and the wavelength-converting element. However, this is only an example and should not be construed as limiting. Alternatively, the medium portion 20 may also be glass containing the light-transmitting material and the wavelength-converting element or a crystal containing the light-transmitting material and the wavelength-converting element. The concentration of the wavelength-converting element in the medium portion 20 may or may not be substantially uniform over the entire length of the medium portion 20 in the second direction D2.

The light-transmitting material may be a fluoride, for example. Examples of the fluoride include calcium fluoride, strontium fluoride, and barium fluoride.

The wavelength-converting element is a rare-earth element. The wavelength-converting element includes one or more elements selected from the group consisting of, for example, Pr, Tb, Ho, Dy, Er, Eu, Nd, and Mn. The wavelength-converting element is contained, in the medium portion 20, as an ion of the rare-earth element, which includes, for example, an ion of Pr ($Pr^{3+}$) and an ion of Tb ($Tb^{3+}$).

The wavelength-converting element is excited by the excitation light P1. In addition, the wavelength-converting element may be excited not only by the excitation light P1 but also by the light produced by amplifying the spontaneous emission of light, emitted from another wavelength converting element other than the wavelength-converting element itself, as internal seed light, i.e., an amplified spontaneous emission (ASE) of light. The wavelength converting element thus excited emits not only an ASE unique to the constituent element of the wavelength converting element but also partially coherent light P3 (stimulated emission of light) having the same wavelength as the seed light P2. The excitation light P1 includes a blue light ray, for example. In this case, the wavelength of the blue light ray may be, for example, equal to or longer than 420 nm and shorter than 480 nm and is preferably equal to or longer than 430 nm and equal to or shorter than 470 nm. The blue light ray may have a wavelength of 440 nm $\pm$ 5 nm, for example. The wavelengths of the ASE and the seed light P2 are longer than the wavelength of the excitation light P1. $Pr^{3+}$ is a material that may emit either an ASE or amplified seed light in the cyan to red range. The intensity of the stimulated emission of light depends on the respective intensities of the excitation light P1, the internal seed light (the spontaneous emission of light), and the seed light P2. If the medium portion 20 contains $Pr^{3+}$ and $Tb^{3+}$, then $Tb^{3+}$ is excited by absorbing an ASE from $Pr^{3+}$ and may produce an ASE having a wavelength unique to $Tb^{3+}$.

$Pr^{3+}$ is a material which may produce stimulated emissions of light having wavelengths of 480 nm, 520 nm, 605 nm, and 640 nm, respectively. $Tb^{3+}$ is a material which may be excited by the light produced from the $Pr^{3+}$ and having a wavelength of 480 nm to produce a stimulated emission of light having a wavelength of 550 nm.

In the light-emitting device 1 according to the first embodiment, the optical amplifier 2 further includes at least one optical element 25 (refer to FIGS. 3B and 4). The optical element 25 causes part of the excitation light P1, which has been incident on the medium portion 20, to be dispersed in a direction aligned with the direction in which the plurality of seed light rays P2 propagates in the medium portion 20. The optical element 25 may be a diffraction gating, for example. The optical amplifier 2 includes a plurality of (e.g., thirty-two) optical elements 25. The plurality of optical elements 25 are arranged on the first surface 21 and second surface 22 of the medium portion 20. In the following description, the plurality of (e.g., sixteen) optical elements 25 arranged on the second surface 22 of the medium portion 20 will be hereinafter referred to as "optical elements 25A" and the plurality of (e.g., sixteen) optical elements 25 arranged on the first surface 21 of the medium portion 20 will be hereinafter referred to as "optical elements 25B" for the sake of convenience of description. In this optical amplifier 2, the number of the optical elements 25A provided is the same as the number of the optical elements 25B provided. However, this is only an example and should not be construed as limiting. The plurality of optical elements 25A and the plurality of optical elements 25B are arranged to form two m × n matrices (where m and n are four), of which the row direction is defined by the second direction D2 (refer to FIG. 3A) and the column direction is defined by the third direction (refer to FIG. 3A). The plurality of optical elements 25A are spaced from each other in each of the second direction D2 and the third direction D3. Likewise, the plurality of optical elements 25B are also spaced from each other in each of the second direction D2 and the third direction D3. The plurality of optical elements 25A and the plurality of optical elements 25B do not overlap with each other in the first direction D1. When viewed in the first direction D1, m optical elements 25A and m optical elements 25B are arranged in line in the second direction D2 to alternate with each other one by one.

(3) Operation of light-emitting device

In this light-emitting device 1, the excitation light P1 is incident on the first surface 21 and the second surface 22 of the medium portion 20. In other words, in this light-emitting device 1, the excitation light P1 is incident on the medium portion 20 in a direction intersecting with the direction in which the plurality of seed light rays P2 propagates in the optical amplifier 2. In this embodiment, the excitation light P1 is emitted from the first light source unit 11 and incident on the medium portion 20. In this light-emitting device 1, the plurality of seed light rays P2 are incident on the light incident surface 23 of the medium portion 20. In this embodiment, the plurality of seed light rays P2 are emitted from the second light source unit 12 and incident on the medium portion 20.

Each of the plurality of seed light rays P2 may have a wavelength falling within the range from 430 nm to 720 nm, for example. In order to use the light-emitting device 1 for lighting purposes, each of the plurality of seed light rays P2 preferably has a wavelength falling within the range from 430 nm to 640 nm. When the light-emitting device 1 is used for lighting purposes, for example, the plurality of seed light rays P2 preferably includes at least four seed light rays P2 having mutually different wavelengths in order to output white light with high color rendering performance. In the following description, a seed light ray P2 having the shortest wavelength out of the four seed light rays P2 (refer to FIG. 5) will be hereinafter referred to as a "first seed light ray P21," a seed light ray P2 having the second shortest wavelength will be hereinafter referred to as a "second seed light ray P22," a seed light ray P2 having the third shortest wavelength will be hereinafter referred to as a "third seed light ray P23," and a seed light ray P2 having the fourth shortest wavelength will be hereinafter referred to as a "fourth seed light ray P24" for the sake of convenience of description. Also, in the following description, a partially coherent light ray P3 having the shortest wavelength out of the four partially coherent light rays P3 (refer to FIG. 5) will be hereinafter referred to as a "first partially coherent light ray P31," a partially coherent light ray P3 having the second shortest wavelength will be hereinafter referred to as a "third partially coherent light ray P32," a partially coherent light ray P3 having the third shortest wavelength will be hereinafter referred to as a "third partially coherent light ray P33," and a partially coherent light ray P3 having the fourth shortest wavelength will be hereinafter referred to as a "fourth partially coherent light ray P34" for the sake of convenience of description.

The first seed light ray P21, the second seed light ray P22, the third seed light ray P23, and the fourth seed light ray P24 have wavelengths of, for example, 482 nm, 523 nm, 605 nm, and 637 nm, respectively. In that case, the first partially coherent light ray P31, the second partially coherent light ray P32, the third partially coherent light ray P33, and the fourth partially coherent light ray P34 have wavelengths of 482 nm, 523 nm, 605 nm, and 637 nm, respectively. Note that if the wavelength of the first seed light ray P21 is the wavelength (of 430 nm, for example) of the excitation light P1, the medium portion 20 preferably has as short a length as possible, in order to use a part of the seed light ray P2 with a wavelength of 430 nm as a part of the output light P5.

FIG. 5 schematically illustrates the principle of operation of the light-emitting device 1 containing $Pr^{3+}$ as a wavelength-converting element thereof. In this light-emitting device 1, not only the excitation light P1 that excites the wavelength-converting element but also the plurality of seed light rays P2 that causes the wavelength-converting element excited by the excitation light P1 to produce the partially coherent light rays P3 are incident on the medium portion 20. In FIG. 5, the ordinate represents the energy (e.g., energy of electrons in this case). The upward arrow shown in FIG. 5 indicates absorption of the excitation light P1. The downward arrows shown in FIG. 5 indicate transitions about an amplified spontaneous emission of light and a stimulated emission of light (partially coherent light ray P3). In FIG. 5, the electron $e^-$ is an electron that the wavelength-converting element has.

In the optical amplifier 2, an electron $e^-$ in a ground state E0 of the wavelength-converting element is excited to an excitation level E2 by the excitation light P1 that has been incident on the medium portion 20. In this case, the ground state E0 includes a first energy level E01, a second energy level E02, a third energy level E03, and a fourth energy level E04, which are different from each other and satisfy the inequality: first energy level E01 < second energy level E02 < third energy level E03 < fourth energy level E04.

Then, the electron $e^-$ that has been excited to the excitation level E2 makes a transition to a metastable level E1, which is an energy level lower than the excitation level E2.

In the medium portion 20, when the electron $e^-$ at the metastable level E1 is caused by the fourth seed light ray P24 to make a transition to the fourth energy level E04, for example, a stimulated emission of light (fourth partially coherent light ray P34) having the same wavelength (of 637 nm, for example) as the fourth seed light ray P24 is produced. The fourth seed light ray P24 is a seed light ray P2, of which the wavelength corresponds to the energy difference between the metastable level E1 and the fourth energy level E04 of the ground state E0.

Also, in the medium portion 20, when the electron $e^-$ at the metastable level E1 is caused by the third seed light ray P23 to make a transition to the third energy level E03, for example, a stimulated emission of light (third partially coherent light ray P33) having the same wavelength (of 605 nm, for example) as the third seed light ray P23 is produced. The third seed light ray P23 is a seed light ray P2, of which the wavelength corresponds to the energy difference between the metastable level E1 and the third energy level E03 of the ground state E0.

Furthermore, in the medium portion 20, when the electron $e^-$ at the metastable level E1 is caused by the second seed light ray P22 to make a transition to the second energy level E02, for example, a stimulated emission of light (second partially coherent light ray P32) having the same wavelength (of 523 nm, for example) as the second seed light ray P22 is produced. The second seed light ray P22 is a seed light ray P2, of which the wavelength corresponds to the energy difference between the metastable level E1 and the second energy level E02 of the ground state E0.

Furthermore, in the medium portion 20, when the electron $e^-$ at the metastable level E1 is caused by the first seed light ray P21 to make a transition to the first energy level E01, for example, a stimulated emission of light (first partially coherent light ray P31) having the same wavelength (of 482 nm, for example) as the first seed light ray P21 is produced. The first seed light ray P21 is a seed light ray P2, of which the wavelength corresponds to the energy difference between the metastable level E1 and the first energy level E01 of the ground state E0.

The light-emitting device 1 gives off output light P6 by having the plurality of light rays P4, included in the output light P5 emerging from the optical amplifier 2, synthesized by the lens 17 and the transmissive diffraction grating 18. The output light P6 may be, for example, white light. In FIG. 1, a light ray P4, having the same wavelength as the first seed light ray P21, out of the plurality of light rays P4 is illustrated as a light ray P41, a light ray P4, having the same wavelength as the second seed light ray P22, is illustrated as a light ray P42, a light ray P4, having the same wavelength as the third seed light ray P23, is illustrated as a light ray P43, and a light ray P4, having the same wavelength as the fourth seed light ray P24, is illustrated as a light ray P44.

(4) Configuration for light-emitting system

The light-emitting system 100 includes the light-emitting device 1, the first light source units 11, and the second light source unit 12 as described above. In addition, the light-emitting system 100 further includes a control system for controlling the first light source units 11 and the second light source unit 12.

(4.1) First light source units

Each of the first light source units 11 emits the excitation light P1 (refer to FIG. 4) to excite the wavelength-converting element contained in the medium portion 20 of the optical amplifier 2. The first light source unit 11 may include, for example, a mount board 110 and a plurality of solid-state light-emitting elements 113. The mount board 110 has a first principal surface 111 and a second principal surface 112 opposite from the first principal surface 111. The plurality of solid-state light-emitting elements 113 are mounted on the first principal surface 111 of the mount board 110.

The mount board 110 may be, but does not have to be, a printed wiring board, for example. Alternatively, the mount board 110 may also be a ceramic board or a three-dimensional wiring board, for example.

Each of the plurality of solid-state light-emitting elements 113 may be, for example, a laser light source. The laser light source may be, for example, a semiconductor laser diode that emits a blue laser beam. The first light source unit 11 outputs, as the excitation light P1, the laser beam emitted from each of the plurality of solid-state light-emitting elements 113. In that case, the excitation light P1 may have a wavelength equal to or longer than 440 nm and equal to or shorter than 450 nm, for example. The laser light source does not have to be a semiconductor laser diode that emits a blue laser beam but may also be a semiconductor laser diode that emits a violet laser beam, for example. Alternatively, each of the plurality of solid-state light-emitting elements 113 may also be a light-emitting diode (LED).

An optical coupling method for making the excitation light P1 incident on the optical amplifier 2 may be, but does not have to be, spatial coupling.

In the following description, out of the two first light source units 11, one first light source unit 11 arranged to face the first surface 21 of the medium portion 20 will be hereinafter referred to as a "first light source unit 11A," and the other first light source unit 11 arranged to face the second surface 22 of the medium portion 20 will be hereinafter referred to as a "first light source unit 1 1B" for the sake of convenience of description.

In the light-emitting system 100, the excitation light P1 emitted from the first light source unit 11A is incident on the first surface 21 of the medium portion 20. In this case, on the first surface 21 of the medium portion 20, the excitation light P1 is incident on a plurality of regions respectively overlapping in the first direction D1 with the plurality of solid-state light-emitting elements 113 of the first light source unit 11A. On the second surface 22 of the medium portion 20, the plurality of optical elements 25A described above are arranged in a plurality of regions respectively overlapping in the first direction D1 with the plurality of solid-state light-emitting elements 113 of the first light source unit 11A.

In the light-emitting system 100, the excitation light P1 emitted from the first light source unit 11B is incident on the second surface 22 of the medium portion 20. In this case, on the second surface 22 of the medium portion 20, the excitation light P1 is incident on a plurality of regions respectively overlapping in the first direction D1 with the plurality of solid-state light-emitting elements 113 of the first light source unit 1 1B. On the first surface 21 of the medium portion 20, the plurality of optical elements 25B described above are arranged in a plurality of regions respectively overlapping in the first direction D1 with the plurality of solid-state light-emitting elements 113 of the first light source unit 11B.

(4.2) Second light source unit

In the light-emitting system 100 according to the first embodiment, the second light source unit 12 includes a multi-wavelength light source 120, a collimator lens 13, a transmissive diffraction grating 14, and a lens 15 as shown in FIGS. 1 and 2.

The multi-wavelength light source 120 emits a multi-wavelength light beam P20 including the plurality of seed light rays P2. The multi-wavelength light beam P20 is an incoherent light beam and has directivity.

The collimator lens 13 collimates the multi-wavelength light beam P20 emitted from the multi-wavelength light source 120.

The transmissive diffraction grating 14 separates the multi-wavelength light beam P20 that has been collimated by the collimator lens 13 into a plurality of (e.g., four) seed light rays P2. A material for the transmissive diffraction grating 14 may be, but does not have to be, quartz.

The lens 15 makes the plurality of (e.g., four) seed light rays P2 that have been separated by the transmissive diffraction grating 14 incident onto a plurality of (e.g., four) different regions on the light incident surface 23 of the medium portion 20 of the optical amplifier 2.

(4.3) Control system

The control system includes: a first drive circuit for driving the two first light source units 11; a second drive circuit for driving the second light source unit 12; and a control unit for controlling the first drive circuit and the second drive circuit.

The control unit includes a computer system. The computer system includes, as principal hardware components, a processor and a memory. The functions of the control unit according to the present disclosure are performed by making the processor execute a program stored in the memory of the computer system. The program may be stored in advance in the memory of the computer system. Alternatively, the program may also be downloaded through a telecommunications line or be distributed after having been recorded in some non-transitory storage medium such as a memory card, an optical disc, or a hard disk drive, any of which is readable for the computer system. The processor of the computer system may be made up of a single or a plurality of electronic circuits including a semiconductor integrated circuit (IC) or a large-scale integrated circuit (LSI). As used herein, the "integrated circuit" such as an IC or an LSI is called by a different name depending on the degree of integration thereof. Examples of the integrated circuits include a system LSI, a very-large-scale integrated circuit (VLSI), and an ultra-large-scale integrated circuit (ULSI). Optionally, a field-programmable gate array (FPGA) to be programmed after an LSI has been fabricated or a reconfigurable logic device allowing the connections or circuit sections inside of an LSI to be reconfigured may also be adopted as the processor. Those electronic circuits may be either integrated together on a single chip or distributed on multiple chips, whichever is appropriate. Those multiple chips may be aggregated together in a single device or distributed in multiple devices without limitation. As used herein, the "computer system" includes a microcontroller including one or more processors and one or more memories. Thus, the microcontroller may also be implemented as a single or a plurality of electronic circuits including a semiconductor integrated circuit or a large-scale integrated circuit.

(5) Operation of light-emitting system

The light-emitting system 100 makes the excitation light P1 incident from the first light source units 11 onto the medium portion 20 of the optical amplifier 2 of the light-emitting device 1 and also makes the plurality of seed light rays P2 incident from the second light source unit 12 onto the medium portion 20 of the optical amplifier 2 of the light-emitting device 1. In this manner, the light-emitting system 100 makes the optical amplifier 2 of the light-emitting device 1 give off a multi-wavelength light beam as the output light P5. In addition, the light-emitting system 100 also gives off output light P6 by having the plurality of light rays P4, included in the output light P5 emerging from the optical amplifier 2, synthesized by the lens 17 and the transmissive diffraction grating 18.

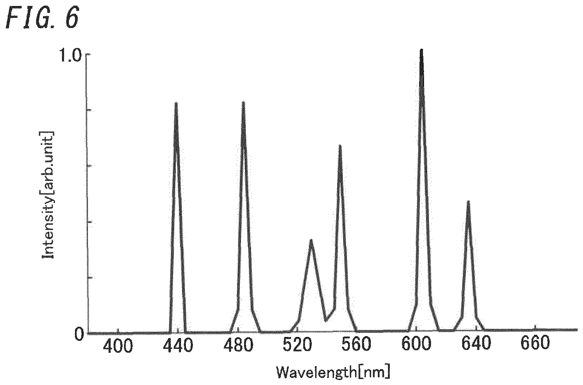

The spectrum of the output light P6 may have bright lines at wavelengths of 440 nm, 482 nm, 523 nm, 550 nm, 605 nm, and 637 nm, respectively, as shown in FIG. 6, for example. The output light P6 having such a discrete spectrum such as the one shown in FIG. 6 has a color rendering index Ra of approximately 80.

(6) Recapitulation

A light-emitting device 1 according to the first embodiment includes an optical amplifier 2 and gives off output light P5 from the optical amplifier 2 by making a plurality of seed light rays P2, having mutually different wavelengths, incident on the optical amplifier 2. The optical amplifier 2 includes a medium portion 20 containing a wavelength-converting element. The optical amplifier 2 has the wavelength-converting element thereof excited by excitation light P1 to produce a plurality of partially coherent light rays P3, of which wavelengths are respectively the same as the mutually different wavelengths of the plurality of seed light rays P2, thereby giving off, as the output light P5, a multi-wavelength light beam. The excitation light P1 has a shorter wavelength than any of the plurality of seed light rays P2 and is incident on the medium portion 20. The multi-wavelength light beam includes a plurality of light rays P4 amplified. The plurality of light rays P4 amplified have wavelengths which are respectively the same as the mutually different wavelengths of the plurality of seed light rays P2.

The light-emitting device 1 according to the first embodiment contributes to providing higher output power.

Also, in the light-emitting device 1 according to the first embodiment, the excitation light P1 is incident onto the medium portion 20 from a direction intersecting with a direction in which the plurality of seed light rays P2 propagates in the optical amplifier 2. This enables the light-emitting device 1 according to the first embodiment to further increase the respective intensities of the plurality of light rays P4 amplified.

Furthermore, in the light-emitting device 1 according to the first embodiment, the optical amplifier 2 further includes an optical element 25. The optical element 25 causes a part of the excitation light P1, which has been incident on the medium portion 20, to be dispersed in a direction aligned with the direction in which the plurality of seed light rays P2 propagates in the medium portion 20. This enables using the excitation light P1 as the output light P5.

A light-emitting system 100 according to the first embodiment includes the light-emitting device 1, a first light source unit 11, and a second light source unit 12, thus contributing to providing higher output power.

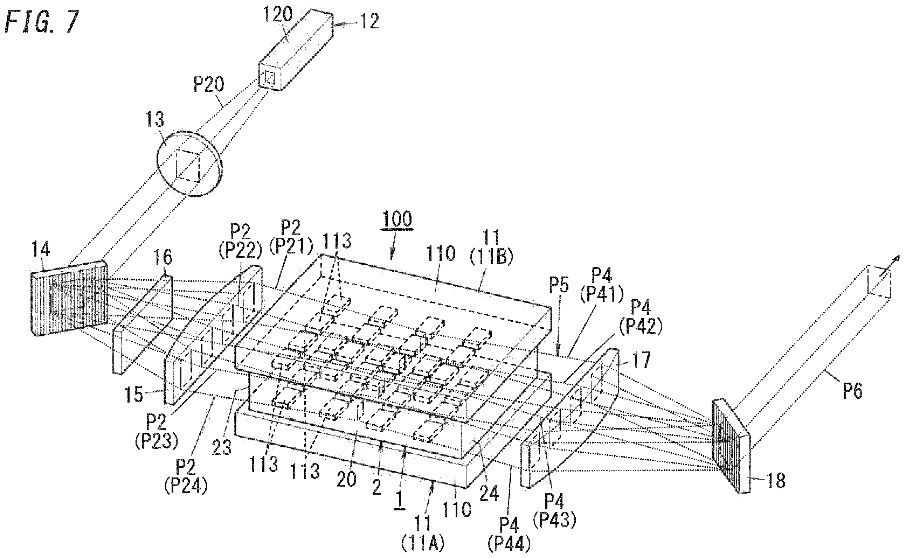

The light-emitting system 100 may further include a spatial light modulator (SLM) 16 as shown in FIG. 7.

The spatial light modulator 16 is included in the second light source unit 12 and disposed between the transmissive diffraction grating 14 and the lens 15. Thus, the plurality of seed light rays P2 that have been separated by the transmissive diffraction grating 14 are incident on the spatial light modulator 16. The spatial light modulator 16 may be a liquid crystal panel, for example. The liquid crystal panel may be controlled by, for example, the control unit to make the transmittance with respect to each of the plurality of seed light rays P2 adjustable. This enables the spatial light modulator 16 to adjust the respective intensities of the plurality of seed light rays P2.

The light-emitting system 100 includes the spatial light modulator 16, thus enabling adjusting the chromaticity of the output light P4 emerging from the optical amplifier 2.

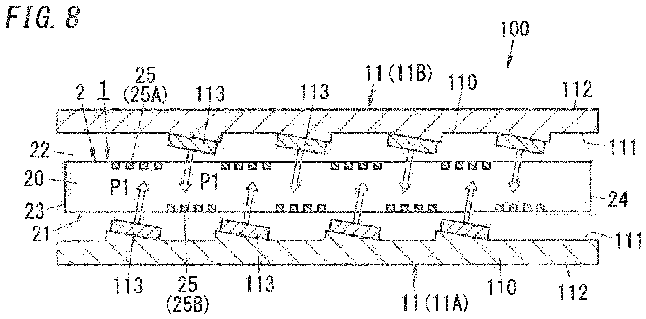

Optionally, in the light-emitting system 100, the first light source unit 11A may be configured to make the excitation light P1 incident onto the first surface 21 of the medium portion 20 in a direction that defines a tilt angle with respect to a normal to the first surface 21 of the medium portion 20 as shown in FIG. 8. In that case, in the light-emitting device 1, the absorption of the excitation light P1 into the medium portion 20 becomes greater than the thickness of the medium portion 20. Thus, the light-emitting system 100 makes it easier for the excitation light P1 that has entered the medium portion 20 through the first surface 21 of the medium portion 20 to excite the wavelength-converting element in the medium portion 20.

In addition, in the light-emitting system 100, the first light source unit 11B may be configured to make the excitation light P1 incident onto the second surface 22 of the medium portion 20 in a direction that defines a tilt angle with respect to a normal to the second surface 22 of the medium portion 20 as shown in FIG. 8. In that case, in the light-emitting device 1, the absorption of the excitation light P1 into the medium portion 20 becomes greater than the thickness of the medium portion 20. Thus, the light-emitting system 100 makes it easier for the excitation light P1 that has entered the medium portion 20 through the second surface 22 of the medium portion 20 to excite the wavelength-converting element in the medium portion 20.

(7) Variations of first embodiment

(7.1) First variation

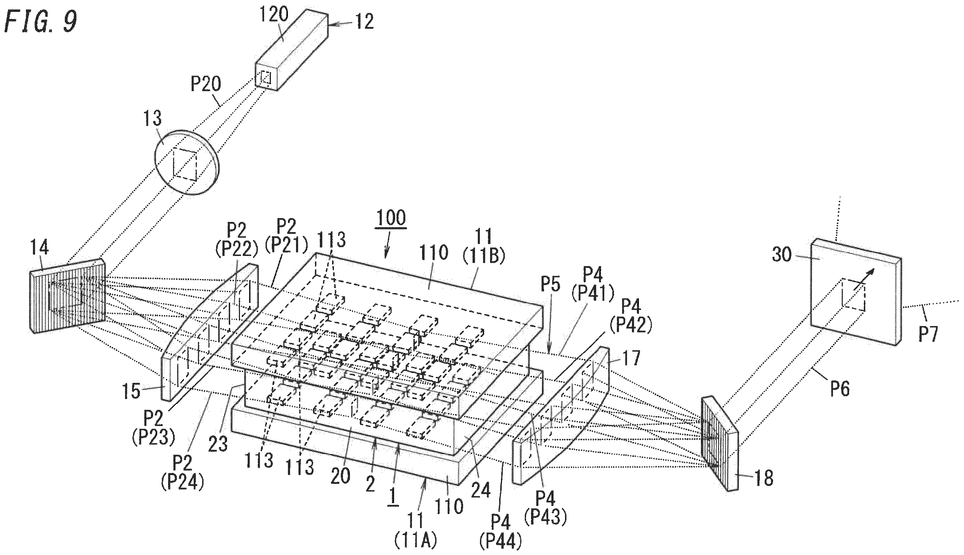

As shown in FIG. 9, a light-emitting device 1 according to a first variation of the first embodiment further includes an optical diffuser 30, which is a difference from the light-emitting device 1 according to the first embodiment. In the following description, any constituent element of the light-emitting device 1 according to this first variation, having the same function as a counterpart of the light-emitting device 1 according to the first embodiment described above, will be designated by the same reference numeral as that counterpart's, and description thereof will be omitted herein.

The optical diffuser 30 may be, for example, an optical diffuser panel made of glass. The optical diffuser 30 diffuses the output light P5 emerging from the optical amplifier 2. In this variation, the light-emitting device 1 makes the optical diffuser 30 diffuse the output light P6 produced by having the plurality of light rays P4, included in the output light P5 emerging from the optical amplifier 2, synthesized by the lens 17 and the transmissive diffraction grating 18. The optical diffuser 30 has the capability of transforming the output light P6 into output light P7 having a different light distribution property from the output light P6. The output light P7 emerging from the optical diffuser 30 has lower coherence than the output light P6 and is suitably used for lighting purposes.

The light-emitting device 1 according to the first variation of the first embodiment includes the same optical amplifier 2 as the light-emitting device 1 according to the first embodiment, thus enabling providing higher output power.

In addition, the light-emitting device 1 and light-emitting system 100 according to the first variation of the first embodiment each include the optical diffuser 30, thus enabling emitting light, of which the coherence is lower than that of the output light P5 emerging from the optical amplifier 2.

(7.2) Second variation

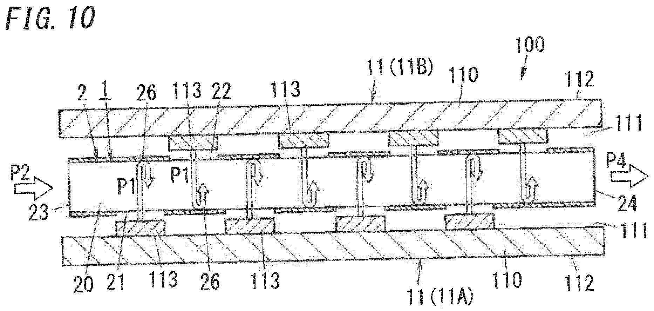

As shown in FIG. 10, a light-emitting device 1 according to a second variation of the first embodiment includes light-reflecting portions 26 instead of the optical elements 25 of the light-emitting device 1 according to the first embodiment, which is a difference from the light-emitting device 1 according to the first embodiment. In the following description, any constituent element of the light-emitting device 1 according to this second variation, having the same function as a counterpart of the light-emitting device 1 according to the first embodiment described above, will be designated by the same reference numeral as that counterpart's, and description thereof will be omitted herein.

Each of the light-reflecting portions 26 reflects the excitation light P1 that has been emitted from the first light source unit 11 and then transmitted through the medium portion 20 in the thickness direction D1 (refer to FIG. 3B) defined for the medium portion 20. Thus, the light-emitting device 1 according to the second variation of the first embodiment makes it easier for the excitation light P1 that has entered the medium portion 20 through the second surface 22 of the medium portion 20 to excite the wavelength-converting element in the medium portion 20.

The light-reflecting portions 26 may be, for example, a metal film or a reflective filter (optical multilayer film).

The light-reflecting portions 26 may also be configured to cause the excitation light P1 to be dispersed in a direction aligned with the direction in which the plurality of seed light rays P2 propagates in the medium portion 20.

(7.3) Third variation

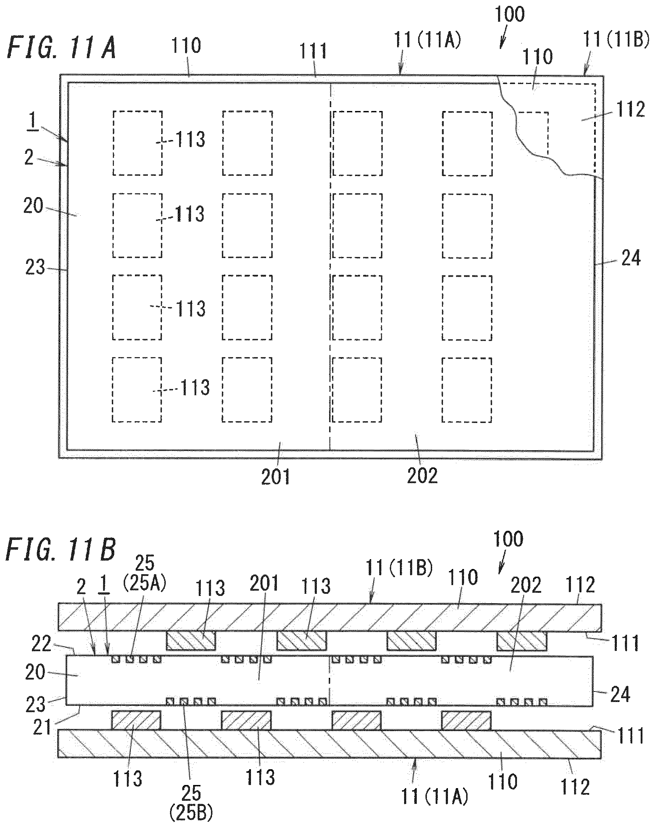

As shown in FIGS. 11A and 11B, in a light-emitting device 1 according to a third variation of the first embodiment, the medium portion 20 includes a plurality of (e.g., two) wavelength-converting regions 201, 202, of which the wavelength-converting elements are of mutually different types and/or have mutually different concentrations. In the following description, any constituent element of the light-emitting device 1 according to this third variation, having the same function as a counterpart of the light-emitting device 1 according to the first embodiment described above, will be designated by the same reference numeral as that counterpart's, and description thereof will be omitted herein.

The plurality of wavelength-converting regions 201, 202 are arranged side by side in the direction in which the plurality of seed light rays P2 propagates (refer to FIG. 4). In other words, the plurality of wavelength-converting regions 201, 202 are arranged side by side in the direction pointing from the light incident surface 23 toward the light emergent surface 24. In the medium portion 20, the wavelength-converting region 201 located closest to the light incident surface 23 out of the plurality of wavelength-converting regions 201, 202 has a higher $Pr^{3+}$ concentration and a lower $Tb^{3+}$ concentration than the wavelength-converting region 202 located second closest to the light incident surface 23. Thus, the light-emitting device 1 according to the third variation of the first embodiment makes it easier to use the light produced by $Pr^{3+}$ of the wavelength-converting region 201 as excitation light for exciting $Tb^{3+}$ of the wavelength-converting region 202.

In the medium portion 20, the wavelength-converting region 201 located closest to the light incident surface 23 out of the plurality of wavelength-converting regions 201, 202 may contain only Pr as the wavelength-converting element and the wavelength-converting region 202 may contain only Tb as the wavelength-converting element. Also, the number of the wavelength-converting regions included in the medium portion 20 does not have to be two but may also be three or more.

(7.4) Fourth variation

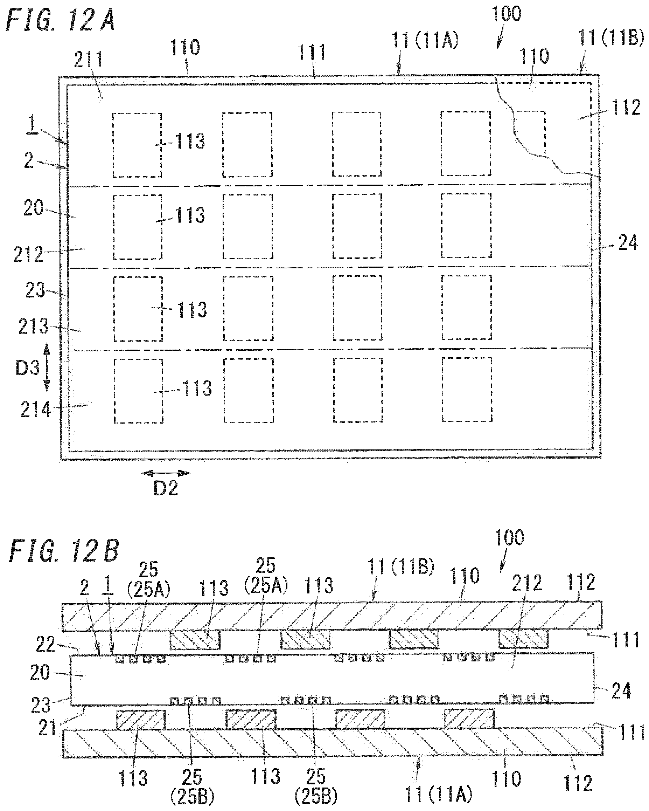

As shown in FIGS. 12A and 12B, in a light-emitting device 1 according to a fourth variation of the first embodiment, the medium portion 20 includes a plurality of (e.g., four) wavelength-converting portions 211, 212, 213, 214, on which the plurality of seed light rays P2 (refer to FIG. 1) are respectively incident. In the following description, any constituent element of the light-emitting device 1 according to this fourth variation, having the same function as a counterpart of the light-emitting device 1 according to the first embodiment described above, will be designated by the same reference numeral as that counterpart's, and description thereof will be omitted herein.

The plurality of wavelength-converting portions 211, 212, 213, 214 are arranged side by side in the third direction D3. The plurality of wavelength-converting portions 211, 212, 213, 214 contain wavelength-converting elements of mutually different types and/or with respectively different concentrations. Thus, the light-emitting device 1 according to the fourth variation of the first embodiment makes it easier to design the respective intensities of the plurality of light rays P41, P42, P43, P44 (refer to FIG. 1) on an individual basis.

Optionally, the light-emitting device 1 may adopt, in combination, the configuration for the medium portion 20 of the light-emitting device 1 according to the fourth variation and the configuration for the medium portion 20 of the light-emitting device 1 according to the third variation.

(7.5) Other variations

For example, the optical elements 25A arranged on the second surface 22 of the medium portion 20 in the light-emitting device 1 may also be interposed between the first surface 21 and the second surface 22 in the thickness direction D1 defined for the medium portion 20 to be spaced from the first surface 21 and the second surface 22. Likewise, the optical elements 25B arranged on the first surface 21 of the medium portion 20 in the light-emitting device 1 may also be interposed between the first surface 21 and the second surface 22 in the thickness direction D1 defined for the medium portion 20 to be spaced from the first surface 21 and the second surface 22.

Also, in the light-emitting system 100 described above, the second light source unit 12 includes the multi-wavelength light source 120, the collimator lens 13, and the transmissive diffraction grating 14. However, this is only an exemplary configuration for the second light source unit 12 and should not be construed as limiting. Alternatively, the second light source unit 12 may also include a plurality of LEDs emitting a plurality of seed light rays P2 having mutually different wavelengths and a plurality of collimator lenses corresponding one to one to the plurality of LEDs and collimating the plurality of seed light rays P2, respectively.

Furthermore, in the light-emitting device 1, one of the plurality of seed light rays P2 may be a near-infrared ray, which may be produced as a partially coherent light ray P3 using, as an excitation source, a light ray having a wavelength of 480 nm and produced by $Pr^{3+}$ or a light ray having a wavelength of 530 nm or 540 nm and produced by $Tb^{3+}$. In that case, the light-emitting device 1 may give off only visible light, only a near-infrared ray, or both visible light and a near-infrared ray. When giving off only visible light, for example, the light-emitting device 1 may improve the color rendering performance of the visible light.

(Second embodiment)

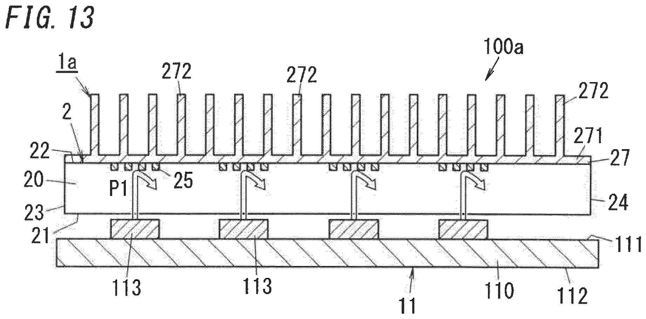

A light-emitting device 1a and light-emitting system 100a according to a second embodiment will be described with reference to FIG. 13.

The light-emitting device 1a according to the second embodiment further includes a heat-dissipating portion 27 disposed on the second surface 22 of the medium portion 20, which is a difference from the light-emitting device 1 according to the first embodiment. The light-emitting system 100a includes the light-emitting device 1a instead of the light-emitting device 1 according to the first embodiment but does not include the first light source unit 11B, which is a difference from the light-emitting system 100 according to the first embodiment.

The heat-dissipating portion 27 includes a plate portion 271 in contact with the second surface 22 of the medium portion 20 and a plurality of fins 272 protruding from the plate portion 271 away from the medium portion 20. The heat-dissipating portion 27 has a higher thermal conductivity than the medium portion 20. A material for the heat-dissipating portion 27 includes for example, a metal (such as aluminum) or an alloy. The material for the plate portion 271 and the material for the plurality of fins 272 are the same in this embodiment but may also be different from each other.

In this embodiment, the plate portion 271 covers the second surface 22 of the medium portion 20 entirely. However, this is only an example and should not be construed as limiting. Alternatively, the plate portion 271 may cover the second surface 22 of the medium portion 20 only partially. The heat-dissipating portion 27 may have any structure without limitation. For example, the heat-dissipating portion 27 may include only the plate portion 271 without the plurality of fins 272. Also, the heat-dissipating portion 27 may be a Peltier element.

The light-emitting device 1a according to the second embodiment includes the heat-dissipating portion 27, thus enabling reducing not only an increase in the temperature of the medium portion 20 but also a variation in the property of the output light P5 (refer to FIG. 1).

(Third embodiment)

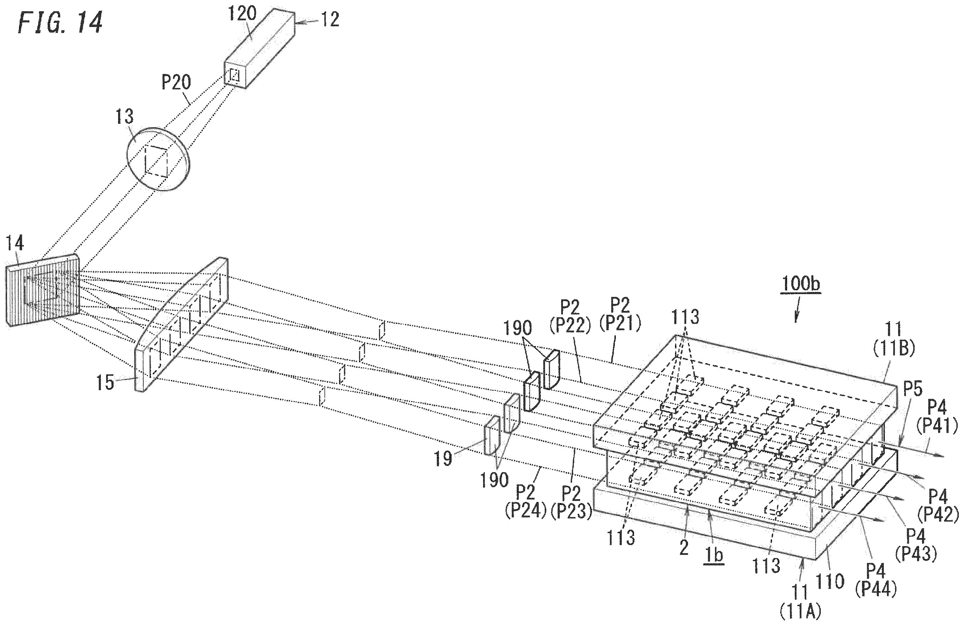

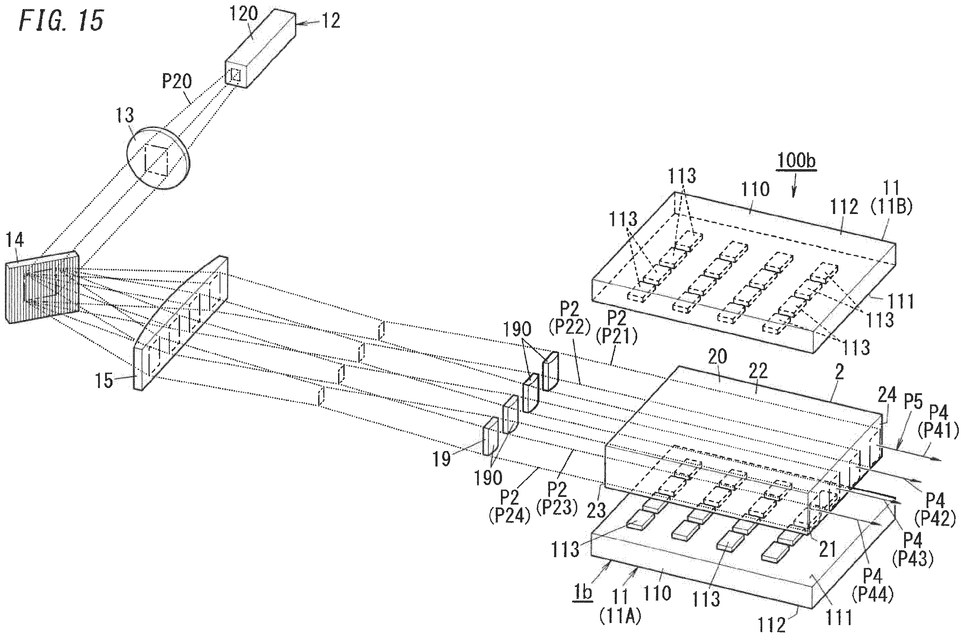

A light-emitting device 1b and light-emitting system 100b according to a third embodiment will be described with reference to FIGS. 14 and 15. In the following description, any constituent element of the light-emitting device 1b and light-emitting system 100b according to this third embodiment, having the same function as a counterpart of the light-emitting device 1 and light-emitting system 100 according to the first embodiment described above, will be designated by the same reference numeral as that counterpart's, and description thereof will be omitted herein.

In the light-emitting system 100b according to the third embodiment, the second light source unit 12 further includes a lens array 19 disposed between the lens 15 and the optical amplifier 2. The lens array 19 includes a plurality of lenses 190 corresponding one to one to the plurality of seed light rays P2. Each of the plurality of lenses 190 is arranged to collimate a corresponding one of the plurality of seed light rays P2 that have been separated by the transmissive diffraction grating 14. The plurality of lenses 190 that form the lens array 19 may be either integrated with each other or provided separately from each other.

Furthermore, the light-emitting system 100b according to the third embodiment includes neither the lens 17 nor the transmissive diffraction grating 18 of the light-emitting device 1 according to the first embodiment but just gives off, without synthesizing, the plurality of light rays P4 amplified. Thus, in the light-emitting device 1b and light-emitting system 100b according to the third embodiment, the plurality of light rays P4 amplified are directly output. Optionally, the light-emitting device 1b and light-emitting system 100b according to the third embodiment may give off the output light P5 including the plurality of light rays P4 amplified through a light-transmitting member that does not synthesize the plurality of light rays P4 amplified. Also, the plurality of light rays P4 amplified may be synthesized on a surface irradiated with the light coming from the light-emitting device 1b and the light-emitting system 100b.

The light-emitting device 1b according to the third embodiment allows the distribution of light to be designed with an increased degree of freedom for a lighting fixture that uses the light-emitting device 1b for lighting source, for example.

(Fourth embodiment)

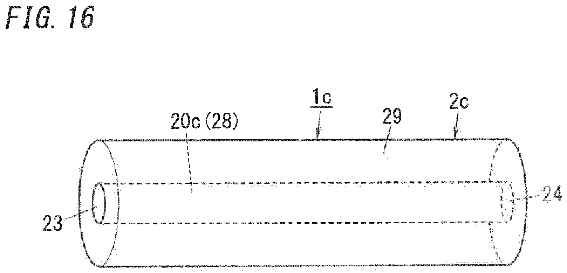

A light-emitting device 1c according to a fourth embodiment will be described with reference to FIG. 16.

The light-emitting device 1c according to the fourth embodiment includes an optical amplifier 2c instead of the optical amplifier 2 of the light-emitting device 1 according to the first embodiment, which is a difference from the light-emitting device 1 according to the first embodiment. In the following description, any constituent element of the light-emitting device 1c according to this fourth embodiment, having the same function as a counterpart of the light-emitting device 1 according to the first embodiment described above, will be designated by the same reference numeral as that counterpart's, and description thereof will be omitted herein.

The optical amplifier 2c includes a medium portion 20c instead of the medium portion 20 of the optical amplifier 2. The medium portion 20c has a circular columnar shape. One longitudinal end face of the medium portion 20c constitutes the light incident surface 23 and the other longitudinal end face thereof constitutes the light emergent surface 24.

The optical amplifier 2c uses the medium portion 20c as its core 28 and further includes a clad 29 covering the outer peripheral surface of the core 28. A cross section, taken along a plane intersecting at right angles with the optical axis, of the core 28 has a circular shape. The clad 29 is arranged coaxially with the core 28.

The refractive index of the clad 29 is smaller than the refractive index of the core 28. The clad 29 does not contain the wavelength-converting element contained in the core 28. The thermal conductivity of the clad 29 is greater than the thermal conductivity of the core 28. As a material for the core 28, a material including a fluoride as a base material such as calcium fluoride, strontium fluoride, or barium fluoride may be adopted. As the wavelength-converting elements, Pr and Tb may be adopted. Meanwhile, as a material for the clad 29, magnesium fluoride, potassium fluoride, or strontium fluoride may be adopted, for example.

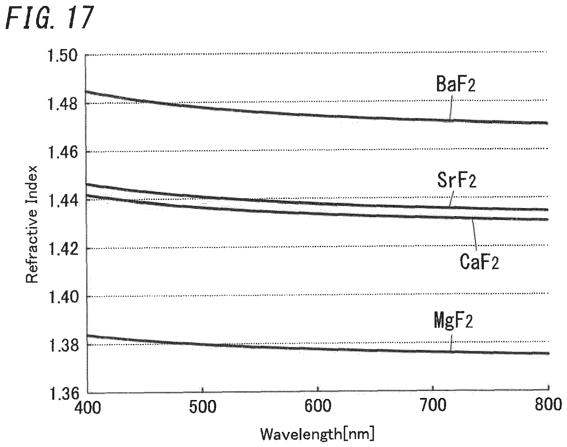

FIG. 17 shows the refractive index-wavelength characteristics of the fluorides described above. The respective refractive indices of calcium fluoride, strontium fluoride, barium fluoride, and magnesium fluoride are also shown in FIG. 17. Note that the refractive index of magnesium fluoride is an average refractive index.

The following Table 1 shows multiple combinations of materials for the core 28 and the clad 29 along with the numerical apertures (NA) associated with the respective combinations:

[Table 1]

| Core | | Clad | NA |
|---|---|---|---|
| Base Material | Wavelength-Converting Element | Base Material | |
| calcium fluoride | $Pr^{3+}$, $Tb^{3+}$ | magnesium fluoride | 0.39-0.40 |
| strontium fluoride | $Pr^{3+}$, $Tb^{3+}$ | magnesium fluoride | 0.41-0.42 |
| strontium fluoride | $Pr^{3+}$, $Tb^{3+}$ | calcium fluoride | 0.11 |
| barium fluoride | $Pr^{3+}$, $Tb^{3+}$ | calcium fluoride | 0.34-0.35 |
| barium fluoride | $Pr^{3+}$, $Tb^{3+}$ | strontium fluoride | 0.32-0.33 |

The optical amplifier 2c may define the numerical aperture in the same way as an optical fiber having a smaller core diameter than the optical amplifier 2c. Thus, the numerical aperture of the optical amplifier 2c may be defined by the following Equation (1):

$$NA = n_i sin\theta_{inmax} = \sqrt{n_{core}^2 - n_{clad}^2}$$

$$(1)$$

In Equation (1), NA is the numerical aperture, $n_i$ is the refractive index of a medium (such as the air) in contact with the light incident surface 23 of the medium portion 20c, $\theta_{inmax}$ is the maximum angle of incidence of the seed light ray P2 (refer to FIG. 1) onto the medium portion 20c, $n_{core}$ is the refractive index of the core 28, and $n_{clad}$ is the refractive index of the clad 29.

In the optical amplifier 2c, the excitation light P1 (refer to FIG. 4) is incident on the core 28 from outside of, and through, the clad 29. In addition, in the optical amplifier 2c, the plurality of seed light rays P2 are also incident on the light incident surface 23 of the medium portion 20c as in the light incident surface 23 of the medium portion 20.

The light-emitting device 1c according to the fourth embodiment includes the optical amplifier 2c, thus enabling providing higher output power. In the light-emitting device 1c according to the fourth embodiment, the heat generated by the core 28 of the optical amplifier 2c is dissipated through the clad 29. Thus, the light-emitting device 1c contributes to improving the heat-dissipation properties.

(Fifth embodiment)

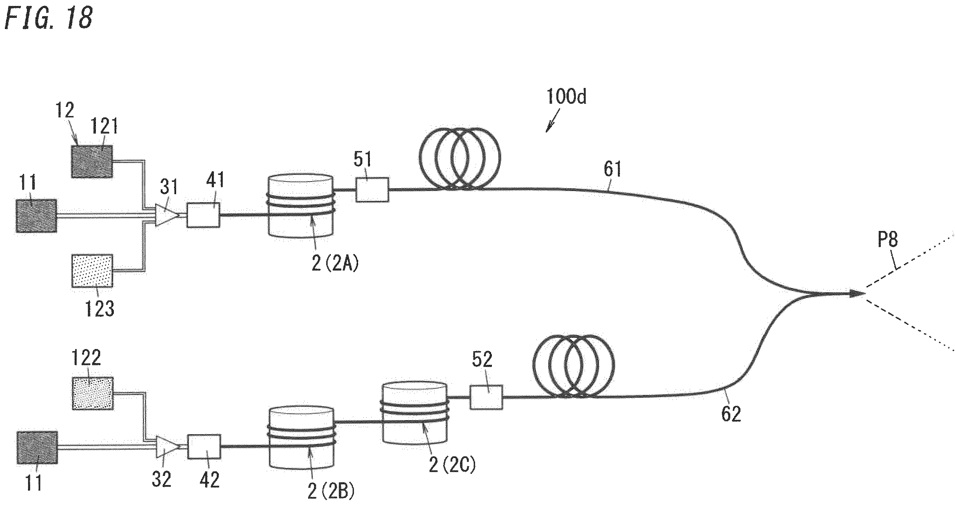

A light-emitting system 100d according to a fifth embodiment will be described with reference to FIG. 18.

The light-emitting system 100d includes a plurality of (e.g., three) optical amplifiers 2, a plurality of (e.g., two) first light source units 11, each emitting the excitation light P1 (refer to FIG. 5), and a second light source unit 12 including a plurality of second light sources 121, 122, 123 respectively emitting a plurality of (e.g., three) seed light rays P2 (refer to FIG. 5). The light-emitting system 100d further includes two combiners 31, 32, two first optical couplers 41, 42, two second optical couplers 51, 52, and two optical fibers 61, 62. In the following description, any constituent element of the light-emitting system 100d according to the fifth embodiment, having the same function as a counterpart of the light-emitting system 100 according to the first embodiment described above, will be designated by the same reference numeral as that counterpart's, and description thereof will be omitted herein.

Each of the two first light source units 11 may be a semiconductor laser diode emitting a blue laser beam having a wavelength of 442 nm, for example. The wavelength of the blue laser beam may be 442 nm, for example. On the other hand, the second light source 121 may be a semiconductor laser diode emitting, as the seed light ray P2 (refer to FIG. 5), a blue laser beam having a longer wavelength (of 450 nm, for example) than the first light source unit 11. The second light source 122 may be a semiconductor laser diode emitting, as the seed light ray P2, a green laser beam having a longer wavelength (of 550 nm, for example) than the second light source 121. The second light source 123 may be a semiconductor laser diode emitting, as the seed light ray P2, a red laser beam having a longer wavelength (of 637 nm, for example) than the second light source 122.

On the combiner 31, incident are the excitation light P1 (blue laser beam) coming from one of the two first light source units 11, the seed light ray P2 (blue laser beam) coming from the second light source 121, and the seed light ray P2 (red laser beam) coming from the second light source 123. On the combiner 32, incident are the excitation light P1 (blue laser beam) coming from the other of the two first light source units 11 and the seed light ray P2 (green laser beam) coming from the second light source 122.

Each of the plurality of optical amplifiers 2, as well as the optical amplifier 2c of the light-emitting device 1c according to the fourth embodiment, has the core 28 as the medium portion 20c and the clad 29 as shown in FIG. 16.

In the light-emitting system 100d, the core 28 of the optical amplifier 2A out of the plurality of optical amplifiers 2 contains $Pr^{3+}$ as the wavelength-converting element, the core 28 of the optical amplifier 2B contains $Pr^{3+}$, and the core 28 of the optical amplifier 2C contains $Tb^{3+}$ as the wavelength-converting element. The optical amplifier 2A is coupled to the combiner 31 via the first optical coupler 41. The optical amplifier 2B is coupled to the combiner 32 via the first optical coupler 42. The optical amplifier 2C is integrated with the optical amplifier 2B. That is to say, the core 28 of the optical amplifier 2C and the core 28 of the optical amplifier 2B are connected to each other, and the clad 29 of the optical amplifier 2C and the clad 29 of the optical amplifier 2B are connected to each other. The respective first optical couplers 41, 42 may be optical fiber couplers, for example. However, this is only an example and should not be construed as limiting. Alternatively, the first optical couplers 41, 42 may also be waveguide couplers or multi-wavelength combiners, for example.

The optical amplifier 2A gives off output light including at least the blue laser beam having the same wavelength as the seed light ray P2 with a wavelength of 450 nm and the red laser beam having the same wavelength as the seed light ray P2 with a wavelength of 637 nm. On the other hand, the optical amplifier 2B gives off output light including at least a partially coherent light ray P3 (refer to FIG. 5) with a wavelength of 484 nm and a seed light ray P2 with a wavelength of 550 nm. Furthermore, the optical amplifier 2C gives off output light including at least the green laser beam having the same wavelength as the seed light ray P2 with a wavelength of 550 nm.

The optical amplifier 2A is coupled to the optical fiber 61 via the second optical coupler 51. The optical amplifier 2C is coupled to the optical fiber 62 via the second optical coupler 52. The optical fibers 61 and 62 are light transmission optical fibers. The respective second optical couplers 51, 52 may be optical fiber couplers, for example. However, this is only an example and should not be construed as limiting. Alternatively, the second optical couplers 51, 52 may also be waveguide couplers or multi-wavelength combiners, for example.

In this light-emitting system 100d, the other end, opposite from the end coupled to the second optical coupler 51, of the optical fiber 61 and the other end, opposite from the end coupled to the second optical coupler 52, of the optical fiber 62 are coupled to each other. Thus, the light-emitting system 100d gives off output light P8 as white light produced by synthesizing together the blue laser beam and red laser beam transmitted through the optical fiber 61 and the green laser beam transmitted through the optical fiber 62.

(Sixth embodiment)

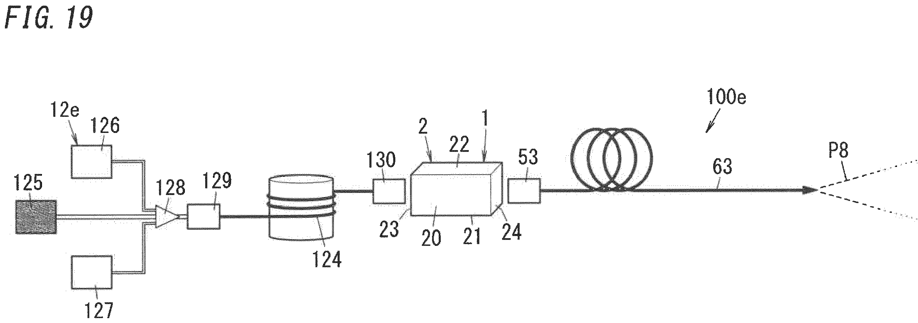

A light-emitting system 100e according to a sixth embodiment will be described with reference to FIG. 19.

The light-emitting system 100e includes a second light source unit 12e instead of the second light source unit 12 of the light-emitting system 100 according to the first embodiment, which is a difference from the light-emitting system 100 according to the first embodiment. In the following description, any constituent element of the light-emitting system 100e according to this sixth embodiment, having the same function as a counterpart of the light-emitting system 100 according to the first embodiment described above, will be designated by the same reference numeral as that counterpart's, and description thereof will be omitted herein.

The second light source unit 12e includes an optical fiber 124, an excitation light source 125, and a plurality of seed light sources 126, 127.

The optical fiber 124 includes a core and a clad. The core of the optical fiber 124 contains a wavelength-converting element (e.g., $Pr^{3+}$ and $Tb^{3+}$). The core has a first end face and a second end face. The core contains the wavelength-converting element over the entire length thereof from the first end face through the second end face. However, this is only an example and should not be construed as limiting. Alternatively, the core may contain the wavelength-converting element in only a local region between the first end face and the second end face. The wavelength converting element of the optical fiber 124 is excited by the excitation light emitted from the excitation light source 125 to produce a spontaneous emission of light having a longer wavelength than the excitation light. In addition, the wavelength-converting element may also be excited by an amplified spontaneous emission of light.

The excitation light source 125 emits the excitation light to excite the wavelength-converting element of the optical fiber 124. The excitation light source 125 may include, for example, a semiconductor laser diode which emits a blue laser beam as the excitation light. The wavelength of the blue laser beam may be, for example, equal to or longer than 440 nm and equal to or shorter than 450 nm.

The plurality of seed light sources 126, 127 emit seed light rays having mutually different wavelengths, which are longer than the wavelength of the excitation light emitted from the excitation light source 125. The seed light source 126 includes, for example, a semiconductor laser diode emitting a green laser beam as the seed light ray. The seed light source 127 includes, for example, a semiconductor laser diode emitting a red laser beam as the seed light ray.

The plurality of seed light sources 126, 127 each emit a seed light ray to cause the wavelength-converting element, excited by either the excitation light or the amplified spontaneous emission of light, to produce a stimulated emission of light. The wavelength of the stimulated emission of light is the same as the wavelength of the seed light ray. In this embodiment, the optical fiber 124 may use part of the amplified spontaneous emission of light as the seed light ray.

The second light source unit 12e further includes a combiner 128 disposed between the excitation light source 125 and the plurality of seed light sources 126, 127 and the optical fiber 124. In addition, the second light source unit 12e further includes an optical coupling member 129 disposed between the combiner 128 and the optical fiber 124. The optical coupling member 129 may include, for example, a lens.

The excitation light emitted from the excitation light source 125 and the seed light rays emitted from the plurality of seed light sources 126, 127 are incident on the first end face of the core of the optical fiber 124 via the combiner 128 and the optical coupling member 129.

The second light source unit 12e further includes another optical coupling member 130 disposed between the optical fiber 124 and the optical amplifier 2. The optical coupling member 130 includes, for example, a lens.

The light emerging from the second end face of the core of the optical fiber 124 is incident on the light incident surface 23 of the medium portion 20 of the optical amplifier 2 via the optical coupling member 130. Thus, the stimulated emissions of light, having mutually different wavelengths and included in the light (mixed color light) emerging from the optical fiber 124, are incident as the plurality of seed light rays P2 (refer to FIGS. 1 and 5) on the optical amplifier 2. The light emitted from the second light source unit 12e may be, for example, white light. The light emitted from the second light source unit 12e is incoherent light. Thus, each of the plurality of seed light rays P2 incident on the optical amplifier 2 has the same wavelength as an associated one of the seed light rays emitted from the plurality of seed light sources 126, 127 of the second light source unit 12e.

As in the light-emitting system 100 according to the first embodiment, the excitation light P1 (refer to FIG. 4) emitted from the first light source unit 11 (refer to FIG. 4) is also incident on the optical amplifier 2.

The light-emitting system 100e further includes an optical coupler 53 and an optical fiber 63. In this light-emitting system 100e, the light emergent surface 24 of the medium portion 20 of the optical amplifier 2 is optically coupled to the optical fiber 63 via the optical coupler 53. The optical coupler 53 includes, for example, a lens 17 (refer to FIG. 1) and a transmissive diffraction grating 18 (refer to FIG. 1). The optical fiber 63 is a light transmission optical fiber.

In this light-emitting system 100e, the light emerging from the optical amplifier 2 is transmitted through the optical fiber 63 via the optical coupler 53. The light-emitting system 100e gives off output light P8, which may be white light, for example, from the optical fiber 63.

(Variations)

Note that the first to sixth embodiments described above are only exemplary ones of various embodiments of the present disclosure and should not be construed as limiting. Rather, the first to sixth exemplary embodiments may be readily modified in various manners depending on a design choice or any other factor without departing from the scope of the present disclosure.

(Aspects)

The first to sixth embodiments and their variations described above may be specific implementations of the following aspects of the present disclosure.

A light-emitting device (1; 1a; 1b; 1c) according to a first aspect includes an optical amplifier (2; 2c) and gives off output light from the optical amplifier (2; 2c) by making a plurality of seed light rays (P2), having mutually different wavelengths, incident on the optical amplifier (2; 2c). The optical amplifier (2; 2c) includes a medium portion (20; 20c) containing a wavelength-converting element. The optical amplifier (2; 2c) has the wavelength-converting element thereof excited by excitation light (P1) to produce a plurality of partially coherent light rays (P3), of which wavelengths are respectively the same as the mutually different wavelengths of the plurality of seed light rays (P2), thereby giving off, as the output light (P5), a multi-wavelength light beam. The excitation light (P1) has a shorter wavelength than any of the plurality of seed light rays (P2) and is incident on the medium portion (20; 20c). The multi-wavelength light beam includes a plurality of light rays (P4) amplified. The plurality of light rays (P4) amplified have wavelengths which are respectively the same as the mutually different wavelengths of the plurality of seed light rays (P2).

The light-emitting device (1; 1a; 1b; 1c) according to the first aspect enables providing higher output power.

In a light-emitting device (1; 1a; 1b; 1c) according to a second aspect, which may be implemented in conjunction with the first aspect, each of the plurality of partially coherent light rays (P3) has a wavelength falling within a range from 480 nm to 640 nm.

The light-emitting device (1; 1a; 1b; 1c) according to the second aspect increases the number of wavelength options of the seed light rays (P2) and may increase the number of the seed light rays (P2).

In a light-emitting device (1; 1a; 1b; 1c) according to a third aspect, which may be implemented in conjunction with the first or second aspect, the plurality of partially coherent light rays (P3) includes at least four partially coherent light rays (P31, P32, P33, P34) having mutually different wavelengths.

The light-emitting device (1; 1a; 1b; 1c) according to the third aspect enables improving the color rendering performance of the output light (P5).

In a light-emitting device (1; 1a; 1b; 1c) according to a fourth aspect, which may be implemented in conjunction with any one of the first to third aspects, the excitation light (P1) includes a blue light ray.

The light-emitting device (1; 1a; 1b; 1c) according to the fourth aspect increases the number of wavelength options of the seed light rays (P2) and may increase the number of the seed light rays (P2).

In a light-emitting device (1; 1a; 1b; 1c) according to a fifth aspect, which may be implemented in conjunction with any one of the first to fourth aspects, the excitation light (P1) is incident onto the medium portion (20; 20c) from a direction intersecting with a direction in which the plurality of seed light rays (P2) propagates in the optical amplifier (2; 2c).

The light-emitting device (1; 1a; 1b; 1c) according to the fifth aspect enables further increasing the respective intensities of the plurality of light rays (P4) amplified.

In a light-emitting device (1; 1a; 1b) according to a sixth aspect, which may be implemented in conjunction with the fifth aspect, the optical amplifier (2) further includes an optical element (25). The optical element (25) causes a part of the excitation light (P1), which has been incident on the medium portion (20; 20c), to be dispersed in a direction aligned with the direction in which the plurality of seed light rays (P2) propagates in the medium portion (20).

The light-emitting device (1; 1a; 1b) according to the sixth aspect enables using the excitation light (P1) as the output light (P5).

In a light-emitting device (1; 1a; 1b) according to a seventh aspect, which may be implemented in conjunction with any one of the first to sixth aspects, the medium portion (20) has a plate shape. The medium portion (20) has a first surface (21) and a second surface (22) facing each other in a thickness direction (D1) defined for the medium portion (20). The excitation light (P1) is incident on the first surface (21) of the medium portion (20). The light-emitting device (1; 1a; 1b) further includes a heat-dissipating portion (27) disposed on the second surface (22) of the medium portion (20).

The light-emitting device (1; 1a; 1b) according to the seventh aspect includes the heat-dissipating portion (27), thus enabling reducing not only an increase in the temperature of the medium portion (20) but also a variation in the property of the output light (P5).

In a light-emitting device (1; 1a; 1b) according to an eighth aspect, which may be implemented in conjunction with any one of the first to seventh aspects, the medium portion (20) has a plate shape. An absorption length of the excitation light (P1) into the medium portion (20) is greater than a thickness of the medium portion (20).

The light-emitting device (1; 1a; 1b) according to the eighth aspect allows the wavelength-converting element to be excited more easily by the excitation light (P1).

In a light-emitting device (1; 1a; 1b; 1c) according to a ninth aspect, which may be implemented in conjunction with any one of the first to eighth aspects, the medium portion (20) includes a plurality of wavelength-converting regions (201, 202) arranged side by side in a direction in which the plurality of seed light rays (P2) propagates.

The light-emitting device (1; 1a; 1b; 1c) according to the ninth aspect makes it easier to use the light produced by a wavelength-converting element ($Pr^{3+}$) in a wavelength-converting region (201) adjacent to a light incident surface (23) as excitation light for exciting a wavelength-converting element ($Tb^{3+}$) in a wavelength-converting region (202) distant from the light incident surface (23).

In a light-emitting device (1; 1a; 1b; 1c) according to a tenth aspect, which may be implemented in conjunction with any one of the first to ninth aspects, the medium portion (20) includes a plurality of wavelength-converting portions (211, 212, 213, 214) on which the plurality of seed light rays (P2) are respectively incident.

The light-emitting device (1; 1a; 1b; 1c) according to the tenth aspect makes it easier to design the respective intensities of a plurality of light rays (P4) on an individual basis.

A light-emitting device (1; 1a; 1b; 1c) according to an eleventh aspect, which may be implemented in conjunction with any one of the first to tenth aspects, further includes an optical diffuser (30). The optical diffuser (30) diffuses the output light (P5) emerging from the optical amplifier (2; 2c).

The light-emitting device (1; 1a; 1b; 1c) according to the eleventh aspect enables giving off light having lower coherence than the output light (P5) emerging from the optical amplifier (2; 2c).

A light-emitting device (1b) according to a twelfth aspect, which may be implemented in conjunction with any one of the first to eleventh aspects, gives off the output light (P5) without synthesizing the output light (P5).

The light-emitting device (1b) according to the twelfth aspect may increase the freedom of design in light distribution in, for example, a lighting fixture which uses the light-emitting device (1b) as a lighting source.

A light-emitting system (100; 100a; 100b; 100c; 100d; 100e) according to a thirteenth aspect includes: the light-emitting device (1; 1a; 1b; 1c) according to any one of the first to twelfth aspects; a first light source unit (11); and a second light source unit (12). The first light source unit (11) emits the excitation light (P1). The second light source unit (12) emits the plurality of seed light rays (P2).

The light-emitting system (100; 100a; 100b; 100c; 100d; 100e) according to the thirteenth aspect enables providing higher output power.

**Reference Signs List**

| | |
|---|---|
| 1, 1a, 1b, 1c | Light-Emitting Device |
| 2, 2c | Optical Amplifier |
| 20 | Medium Portion |
| 21 | First Surface |
| 22 | Second Surface |
| 23 | Light Incident Surface |
| 24 | Light Emergent Surface |
| 25, 25A, 25B | Optical Element |
| 26 | Light-Reflecting Portion |
| 27 | Heat-Dissipating Portion |
| 28 | Core |
| 29 | Clad |
| 201, 202 | Wavelength-Converting Region |
| 211, 212, 213, 14 | Wavelength-Converting Portion |
| 11, 11A, 11B | First Light Source Unit |
| 110 | Mount Board |
| 111 | First Principal Surface |
| 112 | Second Principal Surface |
| 113 | Solid-State Light-Emitting Element |
| 12, 12e | Second Light Source Unit |
| 124 | Optical Fiber |
| 125 | Excitation Light Source |
| 126, 127 | Seed Light Source |
| 128 | Combiner |
| 129 | Optical Coupling Member |
| 13 | Collimator Lens |
| 14 | Transmissive Diffraction Grating |
| 15 | Lens |
| 16 | Spatial Light Modulator |
| 17 | Lens |
| 18 | Transmissive Diffraction Grating |
| 19 | Lens Array |
| 190 | Lens |
| 30 | Optical Diffuser |
| 53 | Optical Coupler |
| 63 | Optical Fiber |
| 100, 100a, 100b, 100c, 100d, 100e | Light-Emitting System |
| D1 | Thickness Direction |
| E0 | Ground State |
| E1 | Metastable Level |

| E2 | Excitation Level |
| P1 | Excitation Light |
| P2 | Seed Light |
| P21 | First Seed Light Ray |
| P22 | Second Seed Light Ray |
| P23 | Third Seed Light Ray |
| P24 | Fourth Seed Light Ray |
| P3 | Partially Coherent Light |
| P31 | First Partially Coherent Light Ray |
| P32 | Second Partially Coherent Light Ray |
| P33 | Third Partially Coherent Light Ray |
| P34 | Fourth Partially Coherent Light Ray |
| P4 | Light |
| P5 | Output Light |
| P6 | Output Light |
| P20 | Multi-Wavelength Light Beam |

**Claims**

1. A light-emitting device comprising an optical amplifier and configured to give off output light from the optical amplifier by making a plurality of seed light rays, having mutually different wavelengths, incident on the optical amplifier,

   the optical amplifier having a medium portion containing a wavelength-converting element,
   the optical amplifier being configured to have the wavelength-converting element thereof excited by excitation light to produce a plurality of partially coherent light rays, of which wavelengths are respectively the same as the mutually different wavelengths of the plurality of seed light rays, thereby giving off, as the output light, a multi-wavelength light beam,
   the excitation light having a shorter wavelength than any of the plurality of seed light rays and being incident on the medium portion,
   the multi-wavelength light beam including a plurality of light rays amplified, of which wavelengths are respectively the same as the mutually different wavelengths of the plurality of seed light rays.

2. The light-emitting device of claim 1, wherein
   each of the plurality of partially coherent light rays has a wavelength falling within a range from 480 nm to 640 nm.

3. The light-emitting device of claim 1 or 2, wherein
   the plurality of partially coherent light rays includes at least four partially coherent light rays having mutually different wavelengths.

4. The light-emitting device of any one of claims 1 to 3, wherein
   the excitation light includes a blue light ray.

5. The light-emitting device of any one of claims 1 to 4, wherein
   the excitation light is incident onto the medium portion from a direction intersecting with a direction in which the plurality of seed light rays propagates in the optical amplifier.

6. The light-emitting device of claim 5, wherein
   the optical amplifier further includes an optical element configured to cause a part of the excitation light, which has been incident on the medium portion, to be dispersed in a direction aligned with the direction in which the plurality of seed light rays propagates in the medium portion.

7. The light-emitting device of any one of claims 1 to 6, wherein

   the medium portion has a plate shape,
   the medium portion has a first surface and a second surface facing each other in a thickness direction defined for the medium portion,
   the excitation light is incident on the first surface, and

the light-emitting device further includes a heat-dissipating portion disposed on the second surface of the medium portion.

8. The light-emitting device of any one of claims 1 to 7, wherein

the medium portion has a plate shape, and
an absorption length of the excitation light into the medium portion is greater than a thickness of the medium portion.

9. The light-emitting device of any one of claims 1 to 8, wherein
the medium portion includes a plurality of wavelength-converting regions arranged side by side in a direction in which the plurality of seed light rays propagates.

10. The light-emitting device of any one of claims 1 to 9, wherein
the medium portion includes a plurality of wavelength-converting portions on which the plurality of seed light rays are respectively incident.

11. The light-emitting device of any one of claims 1 to 10, further comprising an optical diffuser configured to diffuse the output light emerging from the optical amplifier.

12. The light-emitting device of any one of claims 1 to 11, wherein
the light-emitting device is configured to give off the output light without synthesizing the output light.

13. A light-emitting system comprising:

the light-emitting device of any one of claims 1 to 12;
a first light source unit configured to emit the excitation light; and
a second light source unit configured to emit the plurality of seed light rays.

FIG. 1

FIG. 2

*FIG. 3 A*

*FIG. 3 B*

EP 4 166 845 A1

FIG. 4

22

FIG. 5

FIG. 6

FIG. 7

*FIG. 8*

FIG. 9

*FIG. 10*

FIG. 11A

FIG. 11B

FIG. 12 A

FIG. 12 B

FIG. 13

FIG. 14

*FIG. 15*

EP 4 166 845 A1

## FIG. 16

FIG. 17

FIG. 18

EP 4 166 845 A1

EP 4 166 845 A1

*FIG. 19*

## INTERNATIONAL SEARCH REPORT

International application No.

PCT/JP2021/022166

### A. CLASSIFICATION OF SUBJECT MATTER

F21V 29/502(2015.01)i; F21Y 105/10(2016.01)n; F21Y 107/50(2016.01)n; F21Y 115/10(2016.01)n; F21Y 115/30(2016.01)n; F21S 2/00(2016.01)i; F21V 3/00(2015.01)i; F21V 9/32(2018.01)i; F21V 9/38(2018.01)i; H01S 3/042(2006.01)i; H01S 3/0941(2006.01)i; H01S 3/10(2006.01)i

FI: H01S3/10 Z; H01S3/0941; H01S3/042; F21V9/38; F21V9/32; F21V29/502 100; F21V3/00 320; F21S2/00 311; F21S2/00 340; F21S2/00 373; F21Y115:10; F21Y115:30; F21Y105:10; F21Y107:50

According to International Patent Classification (IPC) or to both national classification and IPC

### B. FIELDS SEARCHED

Minimum documentation searched (classification system followed by classification symbols)

H01S3/00-3/02; H01S3/04-3/0959; H01S3/098-3/102; H01S3/105-3/131; H01S3/136-3/213; H01S3/23-4/00; F21S2/00-45/70; F21V1/00-15/04; F21V23/00-37/00; F21V99/00

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2019/131970 A1 (FUJIKURA LTD.) 04 July 2019 (2019-07-04) entire text, all drawings | 1-13 |
| A | WO 2013/111271 A1 (FUJIKURA LTD.) 01 August 2013 (2013-08-01) entire text, all drawings | 1-13 |
| A | JP 2010-080642 A (TOSHIBA CORP.) 08 April 2010 (2010-04-08) entire text, all drawings | 1-13 |
| A | JP 2008-010720 A (TOSHIBA CORP.) 17 January 2008 (2008-01-17) entire text, all drawings | 1-13 |
| A | WO 2017/092789 A1 (UNIVERSITAET STUTTGART) 08 June 2017 (2017-06-08) entire text, all drawings | 1-13 |

☒ Further documents are listed in the continuation of Box C.  ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13 August 2021 (13.08.2021) | 24 August 2021 (24.08.2021) |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

Form PCT/ISA/210 (continuation of second sheet) (January 2015)

**INTERNATIONAL SEARCH REPORT**

International application No.

PCT/JP2021/022166

C (Continuation).   DOCUMENTS CONSIDERED TO BE RELEVANT

| Category* | Citation of document, with indication, where appropriate, of the relevant passages | Relevant to claim No. |
|---|---|---|
| P, X<br>P, A | WO 2021/014853 A1 (INSTITUTE FOR LASER TECHNOLOGY) 28 January 2021 (2021-01-28) paragraphs [0011]-[0045], fig. 1-3 | 1-5, 9-13<br>6-8 |

Information on patent family members

International application no.

PCT/JP2021/022166

| Patent Documents referred in the Report | PuBlication Date | Patent Family | PuBlication Date |
|---|---|---|---|
| WO 2019/131970 A1 | 04 Jul. 2019 | US 2021/066879 A1 entire text, all drawings EP 3734336 A1 CN 111566526 A | |
| WO 2013/111271 A1 | 01 Aug. 2013 | US 2015/0318660 A1 entire text, all drawings | |
| JP 2010-080642 A | 08 Apr. 2010 | (Family: none) | |
| JP 2008-010720 A | 17 Jan. 2008 | (Family: none) | |
| WO 2017/092789 A1 | 08 Jun. 2017 | (Family: none) | |
| WO 2021/014853 A1 | 28 Jan. 2021 | (Family: none) | |

Form PCT/ISA/210 (patent family annex) (January 2015)

**EP 4 166 845 A1**

**Patent documents cited in the description**

- JP 2018195627 A